# EUROPEAN PATENT SPECIFICATION

(11) **EP 3 548 539 B1**
(45) Date of publication and mention of the grant of the patent: **08.07.2026**
(21) Application number: 17821752.7
(22) Date of filing: 20.11.2017
(51) Int. Cl.: C08G 63/692, C08G 59/40, C08G 59/42

(54) **ACTIVE ESTER CURING AGENT COMPOUND FOR THERMOSETTING RESINS, FLAME RETARDANT COMPOSITION COMPRISING SAME, AND ARTICLES MADE THEREFROM**
AKTIVE ESTERHÄRTENDE VERBINDUNG FÜR WÄRMEHÄRTBARE HARZE, FLAMMHEMMENDE ZUSAMMENSETZUNG DAMIT UND DARAUS HERGESTELLTE GEGENSTÄNDE
COMPOSÉ À BASE DE DURCISSEUR À L'ESTER ACTIF POUR RÉSINES THERMODURCISSABLES, COMPOSITION IGNIFUGE COMPRENANT CELUI-CI, ET ARTICLES FABRIQUÉS À PARTIR DE CELUI-CI

(30) Priority: 30.11.2016 US 201662427998 P
(43) Date of publication of application: 09.10.2019
(73) Proprietor: ICL-IP America Inc., Tarrytown, NY 10591 (US)
(72) Inventor: PIOTROWSKI, Andrew, M., Yorktown Heights NY 10598 (US); ZILBERMAN, Joseph, 32983 Haifa (IL); ZHANG, Meng, White Plains NY 10606 (US); GLUZ, Eran, Hod Hasharon 4532231 (IL); LEVCHIK, Sergei, Croton on Hudson NY 10520 (US)
(74) Representative: Daniels, Stefanie Lisa
(86) International application number: PCT/US2017/062550
(87) International publication number: WO 2018/102177

(56) References cited:
- EP-A1- 2 090 610
- EP-A2- 2 090 618
- TACHITA VLAD-BUBULAC ET AL: "Synthesis and Properties of some Phosphorus-containing Polyesters", vol. 18, no. 3, 1 June 2006 (2006-06-01), pages 255 - 264, XP009503328, ISSN: 0954-0083, Retrieved from the Internet <URL:http://journals.sagepub.com/doi/pdf/10.1177/0954008306059504> [retrieved on 20160727], DOI: 10.1177/0954008306059504

## Description

### FIELD OF THE INVENTION

The present invention relates to the field of flame retardants, specifically phosphorus-containing flame retardants for electronic applications such as printed circuit boards.

### BACKGROUND OF THE INVENTION

Thermosetting resins are widely used in both industrial and consumer electronics because of, among other things, their chemical resistance, mechanical strength and electrical properties. For example, thermosetting resins can be used in electronics as protective films, adhesive materials and/or insulating materials, such as interlayer insulating films. To be useful for these applications, the thermosetting resins must provide ease of handling and possess certain physical, thermal, electrical insulation and moisture resistant properties. For example, thermosetting resins having a low dielectric loss tangent, while maintaining a sufficiently low dielectric constant, can possess a desirable combination of properties for electronic applications, especially in situations requiring increased signal speed and frequency.

Thermosetting resins, however, can be flammable. As such, different approaches have been made to impart the desired level of flame resistance to thermosetting resins, such as epoxy resins, such approaches entailing the employment of either halogen-free flame-retardant compounds or halogen-containing flame-retardant compounds. Halogenated compounds, however, are now undergoing additional scrutiny, and the various non-halogenated compounds available are difficult to formulate to provide acceptable properties. It would be desirable to provide the desired level of flame retardancy and acceptable properties such as high glass transition temperature (Tg) and high thermal stability to a thermosetting resin, such as an epoxy resin, while still maintaining a suitable combination of properties for electronic applications.

The largest use for flame retardants in the electronic industry is for PWB (Printed Wiring Board). Such boards are most often made by impregnating glass fabric with a solution of resin and curing agent, then a drying step, followed by an initial curing (B-stage), and then finally curing the same in a press.

Uniform coating of the reinforcing material with a varnish solution is critical to obtain uniform laminates with good properties. Coating of the reinforcing material with a very viscous varnish is difficult or impossible. In addition, it is critical that varnish components dissolve in the solvents commonly used by industry, such as methyl ethyl ketone (MEK), acetone and other commonly used organic solvents. Use of exotic and toxic solvents such as N,N-dimethylformamide (DMF) is less desirable and may be not acceptable in the near future due to the toxicity concerns.

That is why it is critically important that flame retardants used in PWB applications are soluble at a sufficient level in MEK or other organic solvent and that varnish viscosity is within acceptable limits.

In some instances, it is possible to use insoluble additive-type flame retardants as a suspension in the varnish.

This approach however is limited, since additive-type flame retardants must have no negative effect on the cured resin, such as lowering Tg by working as plasticizer. The additive-type flame retardants should also remain solids at a temperature higher than soldering temperature to prevent delamination during this process. This translates to the additive-type flame retardants having a melting point above 290°C. In addition, solid additive flame retardants should be very uniformly milled to a very small particle size of 2 microns or less in order to be effectively dispersed in the cured matrix.

Use of reactive and soluble flame retardants in varnishes for PWB are thus preferred since reactive flame retardants become part of the resin during the crosslinking process. Flame retardants that are polymeric are the most preferred since they have low toxicity and the lowest impact on the environment. Unfortunately, however, most polymers have limited solubility in organic solvents which are commonly used in epoxy laminate preparation. Furthermore, the polymer solutions have generally high viscosities which makes handling the varnish extremely difficult.

Some use of polymeric flame retardants has been described in JP 61136519 A**,** JP 61055115 A and JP 61078832 A**.** Polymers reported in these Japanese patents are prepared by polycondensation between DOPO-HQ (10-(2',5'-dihydroxyphenyl)-9,10-dihydro-9-oxa-10-phosphaphenanthrene-10-oxide) and isophthalic acid using a 1:0.8 - 1:1.2 molar ratio, with dimethyltin maleate as a catalyst, at temperatures as high as 280-340°C in vacuum, reaching 0.1 torr at the end of polycondensation. The final products so obtained are high molecular weight polyesters with degree of polymerization over 40.

Phosphorus-containing polyesters derived from 2-(6-oxido-6H-dibenz<c,e><1,2>oxaphosphorin-6-yl)-1,4-benzenediol and aromatic diacids are disclosed in Synthesis and Properties of some Phosphorus-containing Polyesters (Tachita Vlad-Bubulac et al., High Performance Polymers, 18, 255-264, 2006).

Epoxy resin compositions comprising polyester flame-retardants including DOPO derivatives are known from EP 2 090 618 A.

As shown in Comparative Example 1 below such polymers described in these Japanese patents are not soluble in methyl ethyl ketone (MEK) or many other organic solvents with the exception of DMF. However, even for the highly polar solvent DMF, only low polymer concentration solutions could be effectively prepared due to the exceptionally high viscosity of such polymers.

### SUMMARY OF THE INVENTION

The inventors herein have unexpectedly discovered a polymeric reactive flame retardant (A) (i.e., those of the general formula (I) described herein) with excellent solubility in MEK, and other organic solvents used commonly in the epoxy laminate preparation. Solutions of the polymeric flame retardant of the invention possess acceptable viscosity at concentrations required for varnish preparation, such as from about 200 to about 3,000 cP, preferably from about 700 to about 2,000 cP at 25°C as determined for 70 wt.-% solution in MEK by Brookfield Viscometer. In one non-limiting examples, the polymer can be prepared from DOPO-HQ (10-(2',5'-dihydroxyphenyl)-9,10-dihydro-9-oxa-10-phosphaphenanthrene-10-oxide) and isophthalic acid and has the CAS registry number 105430-15-7. The high molecular weight polymers described in Japanese patents are not soluble in organic solvents commonly employed in the epoxy industry such as MEK, and even their low concentrated solutions in DMF are too viscous (>3,000 cP) for varnish preparation.

Surprisingly the inventors herein have found that the solubility of the polymers made from DOPO-HQ and isophthalic acid can be dramatically improved by strictly controlling their molecular weight during polycondensation.

Being soluble in organic solvents, such polymers (of general formula (I)) are much improved from the polymeric flame retardants previously used. It was surprisingly found that the polymers soluble, for example in MEK, have weight-average molecular weight (Mw) of from about 1,000 to about 20,000 which corresponds to degree of polymerization between 1 and about 40. Preferably, the Mw of the polymers of the formula (I) herein are from about 1,100 to about 15,000 and most preferably from about 1,200 to about 5,000. The polymers with a molecular weight higher than about 20,000 are not soluble in common solvents (e.g. MEK) used for formulating thermosetting resin. The polymers with a weight-average molecular weight lower than 1,000 results in inferior properties in the cured epoxy laminate, as shown in Example 5-6 below, where glass transition temperature (Tg) is significantly lower when using such low molecular weight polymers.

It is therefore a feature of the present invention to provide a compound(s), which can concurrently function as a flame retardant and as an active ester curing agent for thermosetting resins, such as epoxy resins, which cured epoxy resins can be employed in electronic applications while imparting high thermal resistance and thermal stability, high adhesive force, low water absorbance, low dielectric loss tangent, and simultaneously, a sufficiently low dielectric constant. It is known that many phosphorus-containing flame retardants react with epoxy resins with the formation of highly polar hydroxyl groups. For this reason, it is difficult to achieve good electrical properties in the cured products. In addition, most of the known flame retardants for epoxy resins are monofunctional or bifunctional, thus impairing the cross-linking density of the cured resin, which is finally reflected in a reduced glass-transition temperature.

The solvent (B) described herein can be those commonly used in thermosetting formulations, or in the production of epoxy laminates, such as in the manufacture of printed wiring boards, and can be selected from the group consisting of methyl ethyl ketone, acetone, 1-methoxy-2-propanol, tetrahydrofuran, methyl cellosolve, toluene, xylene, propylene glycol methyl ether and acetate thereof, and combinations thereof. In some embodiments, the solvent (B) can include DMF as a minor component less than 40%, more specifically less than 20% by weight of solution.

In one embodiment, the composition described herein can comprise polymer (I) present in an amount of from about 10 to about 80, more specifically from about 20 to about 70 weight percent and the solvent (B) can be present in an amount of from about 20 to about 90, more specifically from about 30 to about 80 weight percent.

The present invention provides phosphorus-containing flame retardants which are used as polyfunctional curing agents, resulting in a combination of highly satisfactory flame-retarding, mechanical and electrical characteristics in the cured products. In addition, polymers of this invention are soluble in common solvents used in the industry such as MEK. These compounds are phosphorus-containing aromatic polyesters with degree of polymerization from 1 to about 40, preferably from about 2 to about 20. Polymers with degree of polymerization higher than about 40 have limited solubility in organic solvents commonly employed in the epoxy industry. In addition, even the low concentrated solutions are too viscous for intended use. All this significantly hampers the use of such high molecular weight polymers for making epoxy laminates.

When the polymeric flame retardants of the present invention (i.e., those of formula (I)) are used as curing agents, it is possible to reduce the formation of undesirable hydroxyl groups during the curing reaction. In addition, the use of the curing agents of the invention enables an increase in the crosslinking density of the epoxy resin cured articles since these curing agents act as polyfunctional curing agents which have many reactive ester groups per molecule. As a result of their use, the glass transition temperature is high (for example from about 170 to about 230 °C) and the material is useful as an electrical insulating material. In addition, curing agents of the invention can be easily applied on the reinforcing agent such as glass fiber using a varnish solution.

The invention herein further provides for epoxy resin compositions containing the said phosphorus- containing flame-retardant polyfunctional curing agent compounds (i.e., those of formula (I)), that exhibit excellent fire retardant, mechanical and electrical properties.

It will be understood herein that in one non-limiting embodiment the expression "active ester curing agent compound" can be used interchangeably with "curing agent for epoxy resins", "epoxy curing agent", "curing agent for epoxy", "epoxy resin curing agent" and "curing agent", and the like.

### DETAILED DESCRIPTION OF THE INVENTION

There is provided in one embodiment herein a composition comprising:
(A) a phosphorus-containing aromatic polyester of formula (I) having a weight average molecular weight of from 1,000 to 20,000 which is concurrently a flame retardant and an active ester curing agent wherein the formula (1) is: 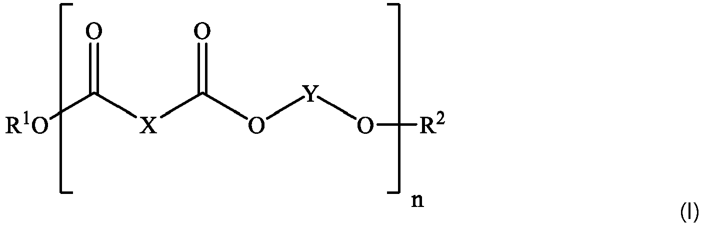
   where X is a bivalent aromatic hydrocarbon group containing from 6 to 12 carbon atoms, which may be optionally substituted, or
   X is a bivalent linear or branched alkylene group of from 1 to 8 carbon atoms, or a bivalent linear or branched alkenylene group of from 2 to 8 carbon atoms,
   Y is 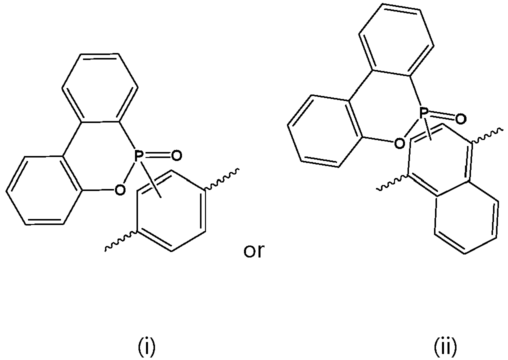 or 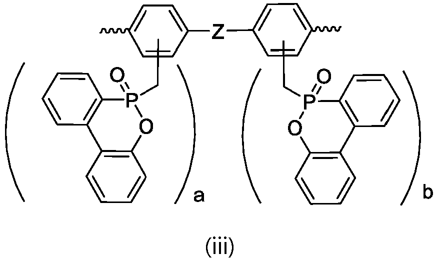
   where Z is selected from the group consisting of a covalent bond, -SO₂-, -C(CH₃)₂-, - CH(CH₃)-, and -CH₂-; a = 0-2; b = 0-2, wherein a and b cannot both be zero;
   wherein the wavy lines of each structure of Y indicate the bonds to the O atoms which Y bridges in the general formula (I);
   R¹ is selected from H, an alkyl group of from 1 to 4 carbon atoms, phenyl, naphthyl 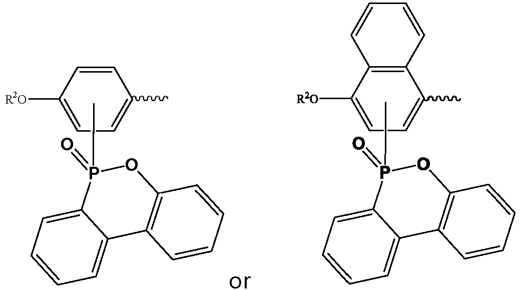
   where R² is H or -C(=O)R³ and
   where R³ is selected from an alkyl group of from 1 to 4 carbon atoms, a phenyl group, a naphthyl group and an aromatic phenol group which is selected from one of a phenol group, o-cresol group, m-cresol group, *p*-cresol group, α-naphthol group, and a *β*-naphthol group,
   and when R² is H, R¹ cannot be phenyl or naphthyl,
   and n is from 1 to 40; and,
(B) a solvent,
   wherein the inherent viscosity of the phosphorus-containing aromatic polyester of formula (I) is not smaller than 0.02 dl/g and not greater than 0.25 dl/g,
   wherein
      - the inherent viscosity of the polymers is determined with a Cannon-Fenske viscometer, by using polymer solutions in N,N-dimethylformamide (DMF) at 25 °C, at a concentration of 20 g/dL and
      - the weight average molecular weight is measured by GPC, as described below.

In one non-limiting embodiment herein, the phosphorus-containing flame-retardant polyfunctional curing agent can comprise a mixture of different structures of the general formula (I), e.g., the mixture can comprise wherein at least 50 wt% of the general formula (I) structures, and preferably more than 70 wt% of the general formula (I) structures are such that Y is chosen from moieties (i) and (ii) as noted above, with the remaining different structures of the general formula (I) being such that Y is chosen from the (iii) moiety noted above.

The weight-average molecular weight Mw of the phosphorus-containing aromatic polyester of the invention is within a range of 1,000 to about 20,000. For this range of molecular weight, the solubility in MEK and other suitable organic solvents is good without any partial precipitation of polymer particles. In addition, this range of molecular weight can provide viscosities of MEK solutions which are suitable for epoxy laminate preparation. The inherent viscosity of the phosphorus-containing aromatic polyester of the invention is not smaller than 0.02 dl/g and not greater than 0.25 dl/g, and more preferably not smaller than 0.05 dl/g and not greater than 0.20 dl/g. The excessively low inherent viscosity resulting from too low a molecular weight would cause a decrease in thermal properties of the cured product. On the other hand, an excessively high inherent viscosity results in deficient flowability and reduces formability of cured product due to high viscosity.

The polymeric polyfunctional curing agent of the invention having the inherent viscosity within this range can be dissolved up to 70 wt% in MEK. These 70 wt.-% solutions are homogeneous, transparent, and stable at room temperature, without any precipitation of solids over a period of 1 month.

### EXAMPLES

Solubility in MEK of the phosphorus-containing aromatic polyester of the invention was evaluated by the following procedure. Mixtures of the polymers in MEK with concentrations of 50 and 70% were prepared in screw bottles and kept in a shaker at 60°C over a period of 4 h. When the full dissolution was attained the transparent mixture was cooled down to room temperature and stored over a period of 1 month. During this period no precipitation was observed. The inherent viscosity of the polymers were determined with a Cannon-Fenske viscometer, by using polymer solutions in N,N-dimethylformamide (DMF) at 25 °C, at a concentration of 20 g/dL. The measurement of the molten viscosity of the polymers was described in Analytical Example 1.

The polymeric polyfunctional curing agents of the invention have an advantage of thermal processing since they melt and soften below 200°C without any solvent.

The phosphorus-containing aromatic polyesters are generally prepared from polyhydric phenol and polyvalent carboxylic acid. The phosphorus-containing aromatic polyesters of the invention may be prepared by ester exchange reaction. An example of an ester exchange reaction is one in which the aromatic polyester is obtained by the step of acetylation of polyhydric phenol by acetic anhydride, followed by acydolysis of the acetylated phenol with polyvalent carboxylic acid. Another way of preparation of the polymers of the invention is by reacting chloranhydrides of the polyvalent acids with polyhydric alcohol followed by acetylation of the hydroxyl endgroups. It will be understood by those skilled in the art that other common methods for making polyesters may be applied for the preparation of the polymers of the invention.

In one non-limiting embodiment herein, the method of making the active ester curing agent of the compound(s) of the general formula (I) described herein can comprise the following general reaction mechanism: 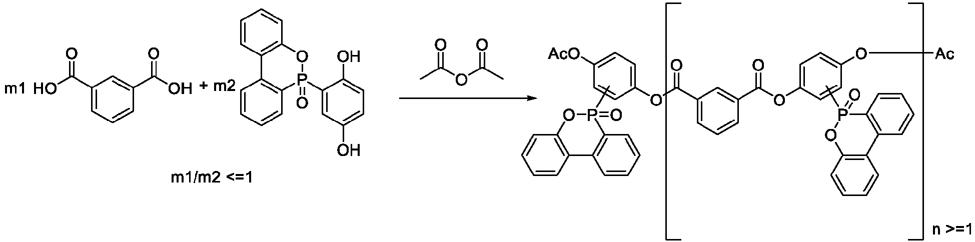 where Ac= acetyl moiety

This reaction does not require the use of any additional solvents. Acetic anhydride is both solvent and reagent. It is used between 1 to 10 molar excess and most preferably 2 to 5 molar excess with respect to DOPO-HQ. The reaction is carried out at 170°C-260°C and most preferably 190°C-240°C for a period of 1-16 hours and most preferably 5-8 hours.

### GPC - Instrument and running conditions

| | |
|---|---|
| Pumping system: | HP model 1100 |
| Detector: | RI: Knauer 2300/2400 |
| | UV: HP model 1100 |
| Columns: | PLgel, Agilent, 300*8.0 mm, 50A+ 100A+ 500A (PLgel 300*7.5) + 1000A |
| Column Temp.: | 60° C |
| Solvent: | THF for Preparation Example 1, and DMF for Preparation Example 2-4 and Comparative Example 1 |
| Flow: | 0.8 ml/min. |
| Injection amount: | 30 µl |

### Preparation Example 1

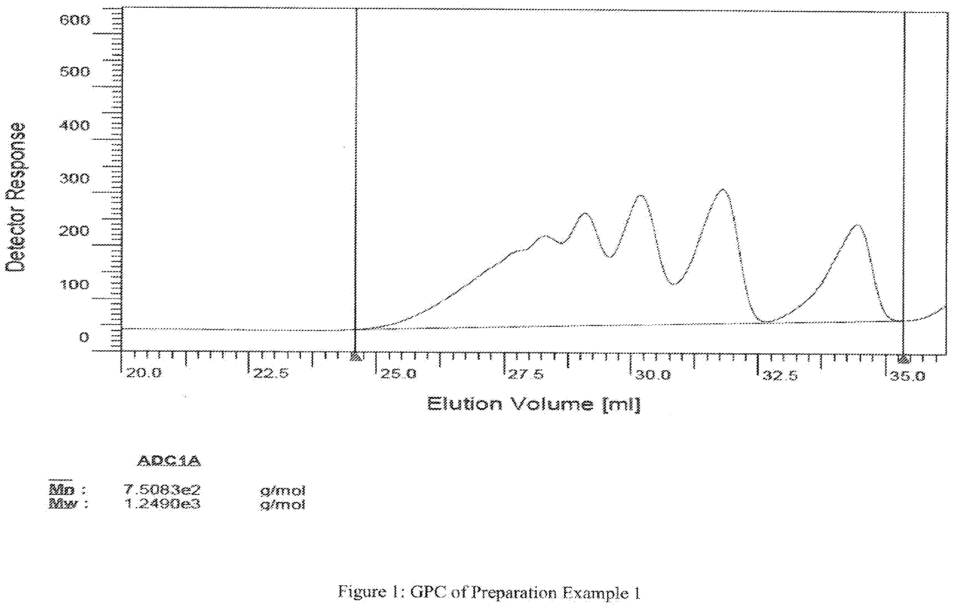

A 1 L 4-necked flask, equipped with a mechanical stirrer, a thermometer and a nitrogen inlet, was charged with DOPO-HQ (293.9 g, 0.9 mol) and acetic anhydride (367.2 g, 3.6 mol). The initial slurry became clear after 30 min at 140°C and the solution was further heated at reflux for an additional 2 h. Isophthalic acid (100 g, 0.6 mol) and 0.04 g potassium acetate were then added and the reaction mixture was heated to 220°C. At this point, vacuum was applied to remove more efficiently both the excess acetic anhydride and the formed acetic acid from the reaction zone, thus accelerating the polycondensation. The temperature was increased to 230 °C. During this period, the vacuum was 30 mbar. The resulting, very viscous, liquid product was poured onto an aluminum plate. The final solid product, obtained in a quantitative yield, had a light-brown color and contained 4% DOPO-HQ-monoacetate and DOPO-HQ-acetate-isophthalate, 10% unreacted DOPO-HQ-Diacetate and 86% oligomers (HPLC area %). The phosphorus content in the product was 6.8%. GPC analysis in THF showed the weight average Mw of 1250 g/mol and number average Mn of 750 g/mol (Figure 1). Inherent viscosity of the product in DMF was 0.17 dL/g. The product had excellent solubility in MEK. Up to 70% of the polymeric DOPO-HQ isophthalate so prepared was dissolved in MEK at 55°C to afford a clear solution. No precipitation was observed upon cooling to room temperature over a period of 1 month.

### Preparation Example 2

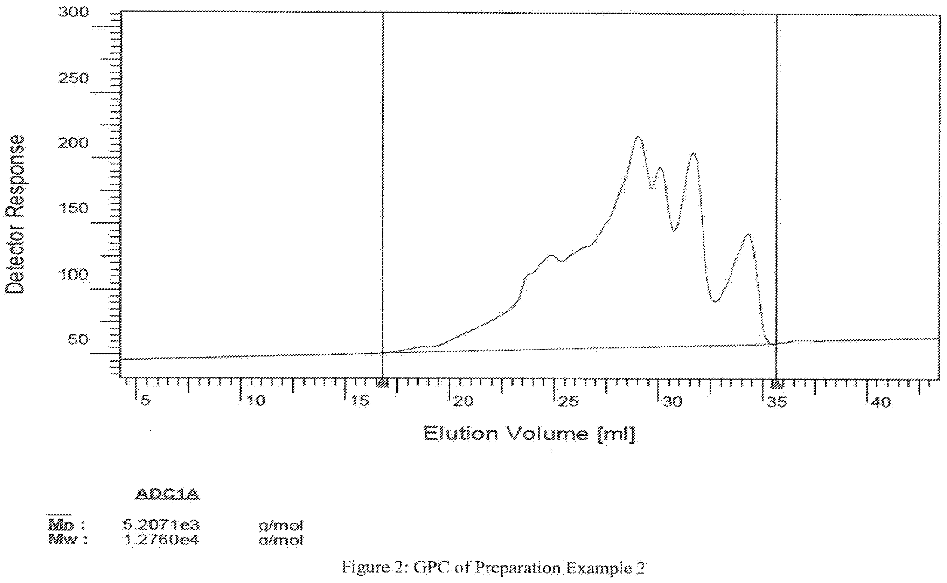

A 0.25 L 4-necked flask, equipped with a mechanical stirrer, a thermometer and a nitrogen inlet, was charged with DOPO (21.6 g, 0.1 mol), benzoquinone (10.3 g, 0.095 mol) and acetic acid (50 ml). The flask was heated to reflux and maintained at that temperature for 3 h to afford a slurry of DOPO-HQ in the solvent. Subsequently, acetic anhydride (30.6 g, 0.3 mol) was introduced, followed by heating to 140°C. Part of the acetic acid was distilled off during the heating. The initial slurry became clear after 30 min at 140°C and the solution was further heated at reflux for an additional 2 h. Isophthalic acid (10 g, 0.06 mol) and 0.01 g potassium acetate were then added and the reaction mixture was heated to 220°C. At this point, vacuum of 30 mbar was applied to remove more efficiently both the excess acetic anhydride and the formed acetic acid from the reaction zone. The resulting, very viscous, liquid product was poured onto an aluminum plate. The final solid product, obtained in a quantitative yield, had a brown color and contained 3% DOPO-HQ-monoacetate and DOPO-HQ-acetate-isophthalate, 6% unreacted DOPO-HQ-Diacetate and 91% oligomers (HPLC area %). The phosphorus content in the product was 6.7%. GPC analysis of the product in DMF showed the Mw of 12760 g/mol and Mn of 5207 g/mol (Figure 2). The product had excellent solubility in MEK. Up to 70% of the polymeric DOPO-HQ isophthalate so prepared was dissolved in MEK at 55°C to afford a clear solution. No precipitation was observed upon cooling to room temperature over a period of 1 month.

### Preparation Example 3

A 0.25 L 4-necked flask, equipped with a mechanical stirrer, a thermometer and a nitrogen inlet, was charged with DOPO-HQ-Diacetate (122 g, 0.3 mol) and heated to 170 °C to full melting. Isophthalic acid ( 33 g, 0.2 mol) and potassium acetate 0.2 g were added and the reaction mixture was heated for 2 h at 280°C without vacuum and 1 h with vacuum of 30 mbar. During that time the formed acetic acid was removed, thus accelerating the polycondensation.

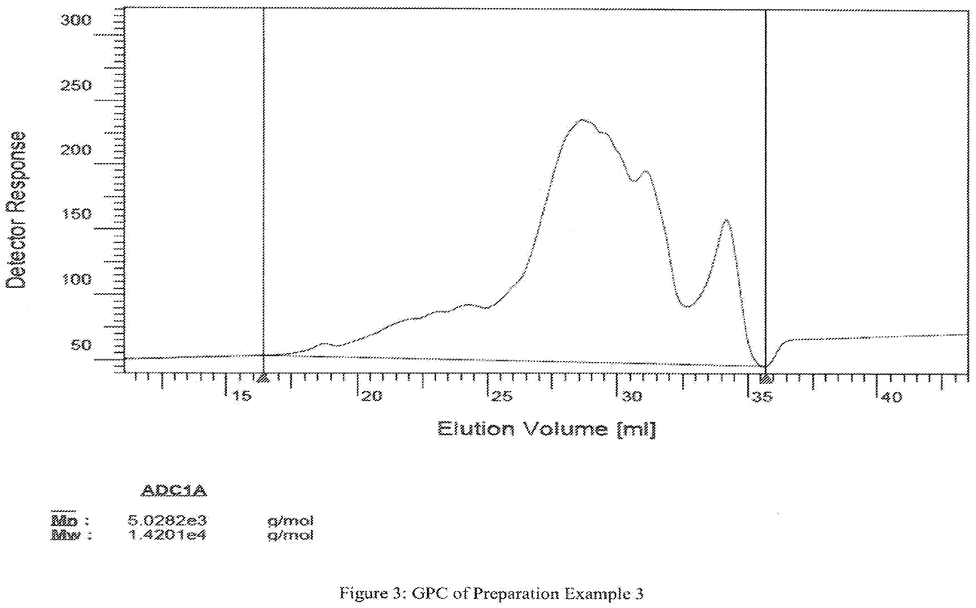

The resulting, very viscous, liquid product was poured onto an aluminum plate. The final solid product, obtained in a quantitative yield, had brown color and contained 4% DOPO-HQ-monoacetate and DOPO-HQ-acetate-isophthalate, 5% unreacted DOPO-HQ-Diacetate and 91% oligomers (HPLC area %). GPC analysis of the product in DMF showed the Mw of 14201 g/mol and Mn 5028 g/mol (Figure 3). The product had excellent solubility in MEK. Up to 60% of the polymeric DOPO-HQ isophthalate so prepared was dissolved in MEK at 55°C to afford a clear solution. No precipitation was observed upon cooling to room temperature over a period of 1 month.

### Preparation Example 4

A 0.25 L 4-necked flask, equipped with a mechanical stirrer, a thermometer and a nitrogen inlet, was charged with DOPO-HQ-Diacetate (49 g, 0.12 mol) and heated to 170 °C to full melting. Isophthalic acid (19.2 g, 0.116 mol) and potassium acetate 0.1 g were added and the reaction mixture was heated for 1 h at 230°C without vacuum and 1 h with vacuum of 30 mbar. During that time the formed acetic acid was removed. The resulting, very viscous, liquid product was poured onto an aluminum plate. The final solid product, obtained in a quantitative yield, had light-brown color and contained 9% DOPO-HQ-monoacetate and DOPO-HQ-acetate-isophthalate, 3.7% unreacted DOPO-HQ-Diacetate and 87.3% oligomers (HPLC area %). GPC analysis of the product in DMF showed the Mw of 19880 g/mol and Mn 6700 g/mol. Up to 60% of the polymeric DOPO-HQ isophthalate so prepared was dissolved in MEK at 55°C to afford a clear solution.

### Comparative Example 1

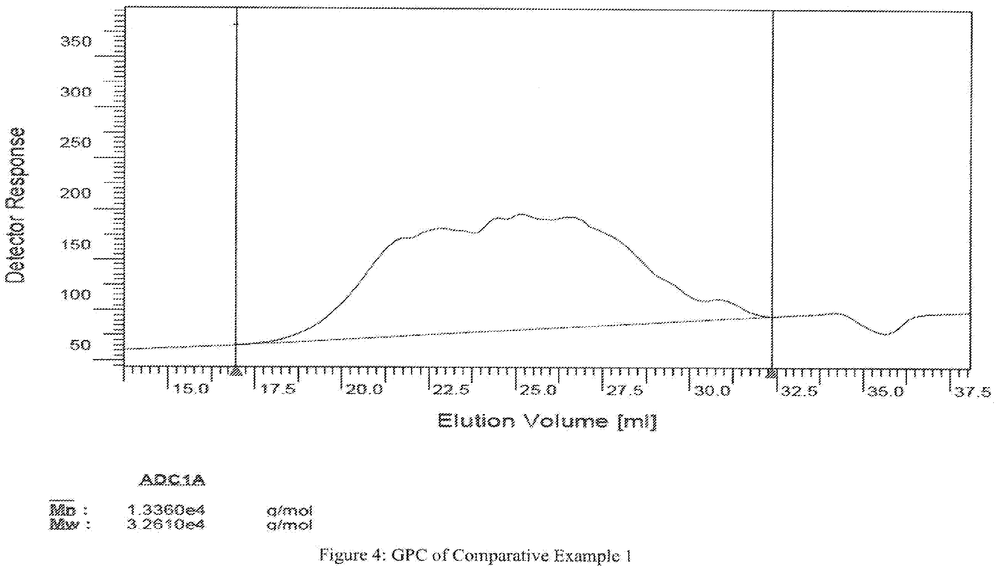

A 0.25 L 4-necked flask, equipped with a mechanical stirrer, a thermometer and a nitrogen inlet, was charged with DOPO-HQ-Diacetate (106 g, 0.26 mol) and heated to 170 °C to full melting. Isophthalic acid (43 g, 0.26 mol) and potassium acetate 0.3 g were added and the reaction mixture was heated at 280°C for 2 h without vacuum and 1 h with vacuum of 30 mbar. As the reaction continued, the mixture became more viscous. During the entire reaction the acetic acid formed was distilled out of the reaction zone to accelerate the polycondensation. The resulting, very viscous, hot liquid product was quickly poured onto an aluminum plate to avoid solidification in the flask. The final solid light-brown product was obtained in a quantitative yield. The product contained 2.8% DOPO-HQ-monoacetate and DOPO-HQ-acetate-isophthalate, 2.2% unreacted DOPO-HQ-Diacetate and 95% higher molecular weight oligomers (HPLC area %). The phosphorus content in the product was 5.4%. GPC analysis in DMF showed the Mw of 32610 g/mol and Mn of 13360 g/mol (Figure 4). The product did not dissolve in MEK at 60°C over a period of 3 h. Inherent viscosity of the product in DMF was 0.32 dL/g.

### Analytical Example 1

A Brookfield DV-II+ Pro Viscometer equipped with SS spindle #31 was used to measure the molten viscosity of polymeric DOPO-HQ isophthalates. About 15 grams of polymeric DOPO-HQ isophthalate was melted in a disposable chamber and allowed to equilibrate at measuring temperatures. The viscosity readings were taken from 200 to 225 °C. The speed was kept between 2 to 30 RPM to obtain a torque above 10%. Polymeric DOPO-HQ isophthalates, soluble in MEK (such as samples made from Preparation Example 1-4), have molten viscosity of 25000 - 625000 cP at 200 °C. Polymeric DOPO-HQ isophthalates, insoluble in MEK (such as sample made from Comparative Example 1), have softening points above 200 °C, and their molten viscosities are not measured.

### Laminate Examples 5-6

The polyester synthesized in Example 1 and low molecular weight DOPO-HQ-diacetate were explored as co-curing agents for the epoxy laminate application. The above compound together with phenolic Novolac was used to cure multi-functional epoxy resins DEN 438 and EPON 164. All the materials information is listed in **Table 1.** The solids content was maintained at 66.67% with the addition of MEK/Dowanol (80/20) solvent mixture. A varnish formulation was prepared therefrom which had a phosphorous content of 2.4-2.7% and the composition contents are shown in **Table 2.**

**Table 1**

| Materials | | |
|---|---|---|
| **Trade Name (Producer)** | **General Information** | **Function** |
| SD-1708 (ex Momentive) | Phenolic novolac | Curing agent |
| DEN 438 (ex Dow Chemicals) | Phenol novolac epoxy | Epoxy resin |
| EPON 164 (ex Momentive) | Cresol novolac epoxy | Epoxy resin |
| Methyl ethyl ketone (ex Fluka) | Butan-2-one | Solvent |
| Dowanol (ex Fluka) | 1-methoxy 2-propanol | Solvent |
| Dimethylformamide (ex Fluka) | N,N-Dimethylformamide | Solvent |
| 2-MI (ex Air Products) | 2-methyl imidazole | Catalyst |
| Glass Cloth (ex BGF Industries) | E-Glass | Reinforcing agent |
| Copper foil (ex Gould Electronics) | JTC, 1.0 oz./ft² | Resistance to oxidation in warm and humid environments and for precise etching behavior and others |

**Table 2**

| Varnish Formulation for Example 5 and 6 | | | | | |
|---|---|---|---|---|---|
| **Formulation** | **DEN 438** | **EPON 164** | **Co-Curing Agent** | **SD-1708** | **2-ml** |
| Exp 5 | 24.3 | 29.7 | 35.8¹ | 10 | 0.065 |
| Exp 6 | 24.0 | 29.4 | 35.3² | 11.3 | 0.02 |

| | | | | | |
|---|---|---|---|---|---|
| ¹ DOPO-HQ-diacetate for Experiment 5 ² Sample made from Preparation Example 1 for Experiment 6 | | | | | |

**Table 3**

| Laminate Properties with formulation as shown in Table 2 | | |
|---|---|---|
| **Laminate Properties** | **Exp 5 (DOPO-HQ-diacetate; Mw < 500)** | **Exp 6 (Sample from Preparation Example 1)** |
| Glass Transition Temperature (DMA - 3°C/min) | 150 | 194 |
| Flammability (UL-94) | V-0 | V-0 |
| Pressure Cooker Test | Pass 30 min | Pass 90 min |

## Claims

1. A composition comprising:
(A) a phosphorus-containing aromatic polyester of formula (I) having a weight average molecular weight of from 1,000 to 20,000 which is concurrently a flame retardant and an active ester curing agent wherein the formula (I) is: 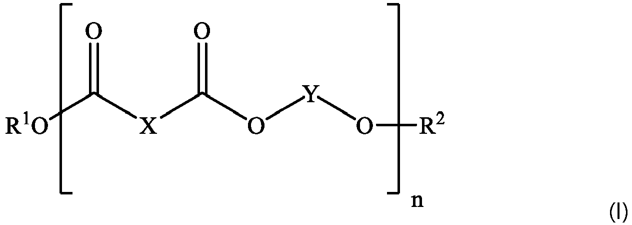
where X is a bivalent aromatic hydrocarbon group containing from 6 to 12 carbon atoms, which may be optionally substituted, or
X is a bivalent linear or branched alkylene group of from 1 to 8 carbon atoms, or a bivalent linear or branched alkenylene group of from 2 to 8 carbon atoms,
Y is 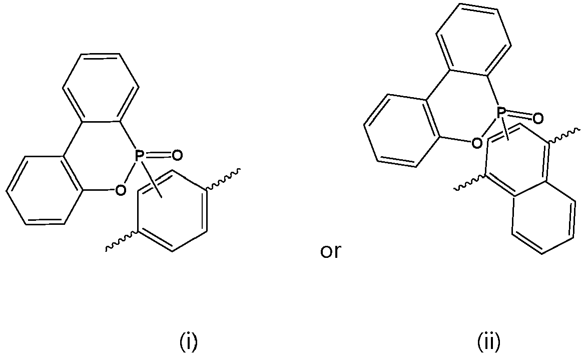 or 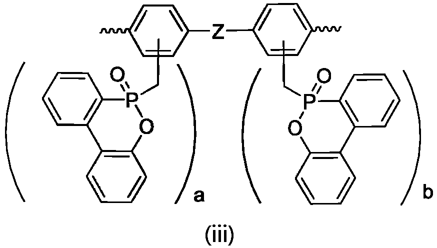
where Z is selected from the group consisting of a covalent bond, -SO₂-, - C(CH₃)₂-, -CH(CH₃)-, and -CH₂-; a = 0-2; b = 0-2, wherein a and b cannot both be zero;
wherein the wavy lines of each structure of Y indicate the bonds to the O atoms which Y bridges in the general formula (I);
R' is selected from H, an alkyl group of from 1 to 4 carbon atoms, phenyl, naphthyl 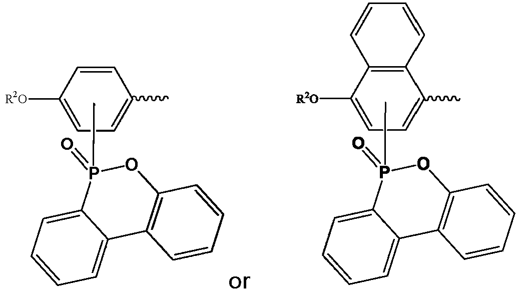
where R² is H or -C(=O)R³ and
where R³ is selected from an alkyl group of from 1 to 4 carbon atoms, a phenyl group, a naphthyl group and an aromatic phenol group which is selected from one of a phenol group, o-cresol group, m-cresol group, *p*-cresol group, α-naphthol group, and a *β*-naphthol group,
and when R² is H, R¹ cannot be phenyl or naphthyl,
and n is from 1 to 40; and,
(B) a solvent,
wherein the inherent viscosity of the phosphorus-containing aromatic polyester of formula (I) is not smaller than 0.02 dl/g and not greater than 0.25 dl/g,
wherein
- the inherent viscosity of the polymers is determined with a Cannon-Fenske viscometer, by using polymer solutions in N,N-dimethylformamide (DMF) at 25 °C, at a concentration of 20 g/dL and
- the weight average molecular weight is measured by GPC, as specified in the description.

2. The composition of Claim 1 wherein the solvent (B) is a solvent used in copper clad laminate preparation.

3. The composition of Claim 1 wherein R¹ is 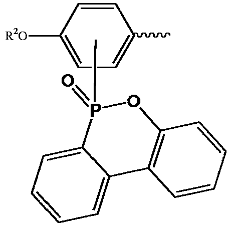 and where X is a bivalent aromatic hydrocarbon group of from 6 to 12 carbon atoms which is optionally substituted with an alkyl or alkoxy group of up to 6 carbon atoms.

4. The composition of Claim 1 wherein R' is an alkyl of from 1 to 4 carbon atoms and where X is a bivalent aromatic hydrocarbon group of from 6 to 12 carbon atoms which is optionally substituted with an alkyl or alkoxy group of up to 6 carbon atoms.

5. The composition of Claim 1 wherein R¹ is 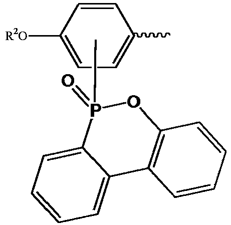 and where X is a bivalent linear or branched alkylene group of from 1 to 8 carbon atoms, or a bivalent linear or branched alkenylene group of from 2 to 8 carbon atoms.

6. The composition of Claim 1 wherein R¹ is H or an alkyl of from 1 to 4 carbon atoms and where X is a bivalent linear or branched alkylene group of from 1 to 8 carbon atoms, or a divalent linear or branched alkenylene group of from 2 to 8 carbon atoms.

7. The composition of Claim 1 wherein X is a bivalent aromatic hydrocarbon group of from 6 to 12 carbon atoms which is optionally substituted with an alkyl or alkoxy group of up to 6 carbon atoms.

8. The composition of Claim 1 wherein X is a divalent linear or branched alkylene group of from 1 to 8 carbon atoms, or a divalent linear or branched alkenylene group of from 2 to 8 carbon atoms.

9. The composition of Claim 1 wherein n is from 1 to 40.

10. The composition of Claim 1 wherein n is from 2 to 40.

11. The composition of Claim 1 wherein n is from 2 to 20.

12. The composition of Claim 1 wherein n is from 3 to 20.

13. The composition of Claim 1 wherein the solvent (B) is selected from the group consisting of methyl ethyl ketone, acetone, 1-methoxy-2-propanol, tetrahydrofuran, methyl cellosolve, toluene, xylene, propylene glycol methyl ether and acetate thereof, and combinations thereof.

## Patentansprüche

1. Zusammensetzung, umfassend:
(A) einen phosphorhaltigen aromatischen Polyester der Formel (I) mit einem gewichtsmittleren Molekulargewicht von 1.000 bis 20.000, der gleichzeitig ein Flammschutzmittel und ein aktives Ester-Härtungsmittel ist, wobei die Formel (I) lautet: 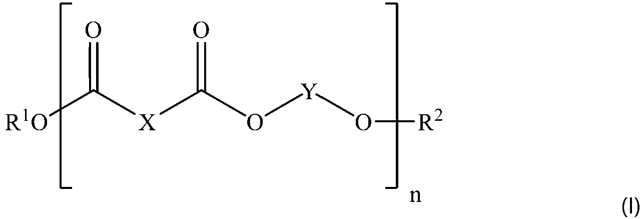
wobei X eine zweiwertige aromatische Kohlenwasserstoffgruppe mit 6 bis 12 Kohlenstoffatomen ist, die gegebenenfalls substituiert sein kann, oder
X eine zweiwertige lineare oder verzweigte Alkylengruppe mit 1 bis 8 Kohlenstoffatomen oder eine zweiwertige lineare oder verzweigte Alkenylengruppe mit 2 bis 8 Kohlenstoffatomen ist,
Y ist 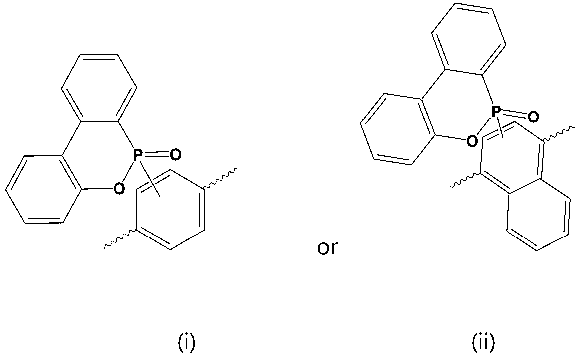 or 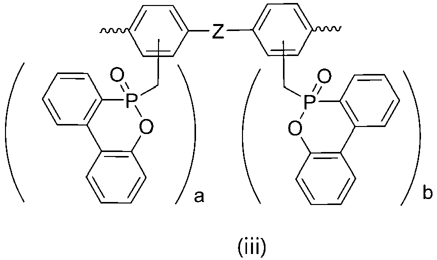
wobei Z aus der Gruppe ausgewählt ist, die aus einer kovalenten Bindung, -SO2-, - C(CH3)2-, -CH(CH3)- und -CH2- besteht; a = 0-2; b = 0-2, wobei a und b nicht beide Null sein können;
wobei die Wellenlinien jeder Struktur von Y die Bindungen zu den O-Atomen anzeigen, die Y in der allgemeinen Formel (I) überbrückt;
R1 ausgewählt ist aus H, einer Alkylgruppe mit 1 bis 4 Kohlenstoffatomen, Phenyl, Naphthyl 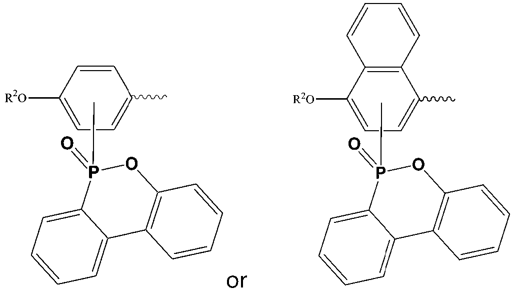
wobei R2 H oder -C(=O)R3 ist und
wobei R3 ausgewählt ist aus einer Alkylgruppe mit 1 bis 4 Kohlenstoffatomen, einer Phenylgruppe, einer Naphthylgruppe und einer aromatischen Phenolgruppe, die ausgewählt ist aus einer Phenolgruppe, einer o-Kresolgruppe, einer m-Kresolgruppe, einer p-Kresolgruppe, einer α-Naphtholgruppe und einer β-Naphtholgruppe,
und wenn R2 H ist, kann R1 nicht Phenyl oder Naphthyl sein,
und n ist 1 bis 40; und
(B) ein Lösungsmittel,
wobei die inhärente Viskosität des phosphorhaltigen aromatischen Polyesters der Formel (I) nicht kleiner als 0,02 dl/g und nicht größer als 0,25 dl/g ist,
wobei
- die inhärente Viskosität der Polymere mit einem Cannon-Fenske-Viskosimeter unter Verwendung von Polymerlösungen in N,N-Dimethylformamid (DMF) bei 25 °C und einer Konzentration von 20 g/dl bestimmt wird und
- das mittlere Molekulargewicht mittels GPC gemessen wird.

2. Die Zusammensetzung nach Anspruch 1, wobei das Lösungsmittel (B) ein Lösungsmittel ist, das bei der Herstellung von kupferkaschierten Laminaten verwendet wird.

3. Die Zusammensetzung gemäß Anspruch 1, wobei R1 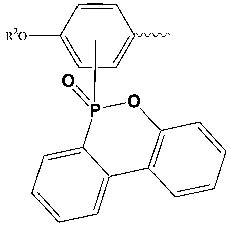 und wobei X eine zweiwertige aromatische Kohlenwasserstoffgruppe mit 6 bis 12 Kohlenstoffatomen ist, die gegebenenfalls mit einer Alkyl- oder Alkoxygruppe mit bis zu 6 Kohlenstoffatomen substituiert ist.

4. Die Zusammensetzung nach Anspruch 1, wobei R1 ein Alkyl mit 1 bis 4 Kohlenstoffatomen ist und wobei X eine zweiwertige aromatische Kohlenwasserstoffgruppe mit 6 bis 12 Kohlenstoffatomen ist, die gegebenenfalls mit einer Alkyl- oder Alkoxygruppe mit bis zu 6 Kohlenstoffatomen substituiert ist.

5. Die Zusammensetzung nach Anspruch 1, wobei R1 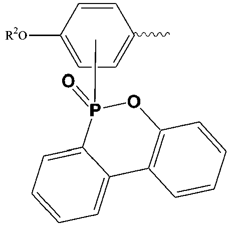 und wobei X eine zweiwertige lineare oder verzweigte Alkylengruppe mit 1 bis 8 Kohlenstoffatomen oder eine zweiwertige lineare oder verzweigte Alkenylengruppe mit 2 bis 8 Kohlenstoffatomen ist.

6. Die Zusammensetzung nach Anspruch 1, wobei R1 H oder ein Alkyl mit 1 bis 4 Kohlenstoffatomen ist und wobei X eine zweiwertige lineare oder verzweigte Alkylengruppe mit 1 bis 8 Kohlenstoffatomen oder eine zweiwertige lineare oder verzweigte Alkenylengruppe mit 2 bis 8 Kohlenstoffatomen ist.

7. Die Zusammensetzung nach Anspruch 1, wobei X eine zweiwertige aromatische Kohlenwasserstoffgruppe mit 6 bis 12 Kohlenstoffatomen ist, die gegebenenfalls mit einer Alkyl- oder Alkoxygruppe mit bis zu 6 Kohlenstoffatomen substituiert ist.

8. Die Zusammensetzung nach Anspruch 1, wobei X eine zweiwertige lineare oder verzweigte Alkylengruppe mit 1 bis 8 Kohlenstoffatomen oder eine zweiwertige lineare oder verzweigte Alkenylengruppe mit 2 bis 8 Kohlenstoffatomen ist.

9. Die Zusammensetzung nach Anspruch 1, wobei n 1 bis 40 ist.

10. Die Zusammensetzung nach Anspruch 1, wobei n 2 bis 40 ist.

11. Die Zusammensetzung nach Anspruch 1, wobei n 2 bis 20 ist.

12. Die Zusammensetzung nach Anspruch 1, wobei n 3 bis 20 ist.

13. Die Zusammensetzung nach Anspruch 1, wobei das Lösungsmittel (B) aus der Gruppe ausgewählt ist, die aus Methylethylketon, Aceton, 1-Methoxy-2-propanol, Tetrahydrofuran, Methylcellosolve, Toluol, Xylol, Propylenglykolmethylether und dessen Acetat sowie Kombinationen davon besteht.

## Revendications

1. Composition comprenant :
(A) un polyester aromatique contenant du phosphore de formule (I) ayant un poids moléculaire moyen en poids compris entre 1 000 et 20 000, qui est à la fois un retardateur de flamme et un agent de durcissement à base d'ester actif, dans laquelle la formule (I) est : 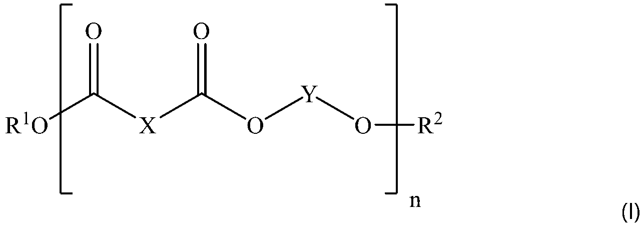
où X est un groupe hydrocarboné aromatique bivalent contenant de 6 à 12 atomes de carbone, qui peut être éventuellement substitué, ou
X est un groupe alkylène bivalent linéaire ou ramifié de 1 à 8 atomes de carbone, ou un groupe alcénylène bivalent linéaire ou ramifié de 2 à 8 atomes de carbone,
Y est 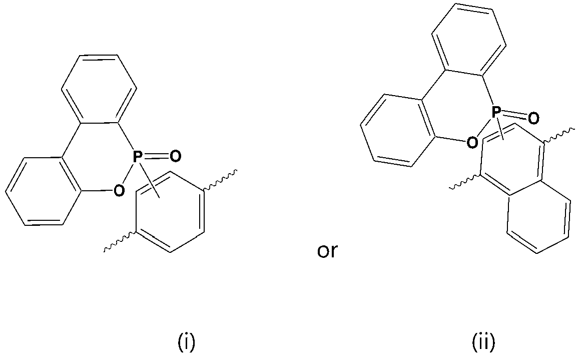 or 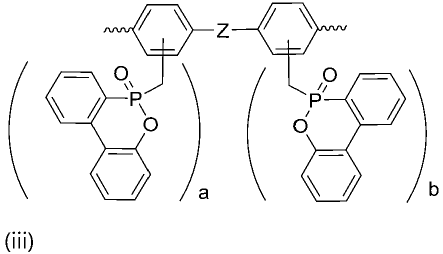
où Z est choisi parmi le groupe constitué d'une liaison covalente, -SO2-, - C(CH3)2-, -CH(CH3)- et -CH2- ; a = 0-2 ; b = 0-2, où a et b ne peuvent pas être tous deux égaux à zéro ;
où les lignes ondulées de chaque structure de Y indiquent les liaisons aux atomes O que Y relie dans la formule générale (I) ;
R1 est choisi parmi H, un groupe alkyle de 1 à 4 atomes de carbone, phényle, naphtyle 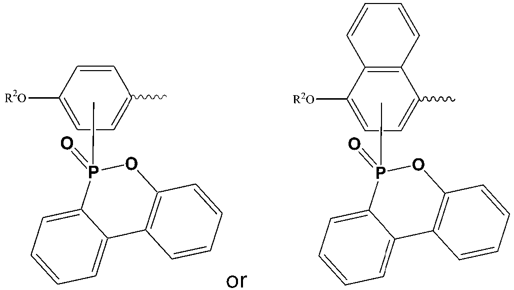
où R2 est H ou -C(=O)R3 et
où R3 est choisi parmi un groupe alkyle de 1 à 4 atomes de carbone, un groupe phényle, un groupe naphtyle et un groupe phénol aromatique qui est choisi parmi un groupe phénol, un groupe o-crésol, un groupe m-crésol, un groupe p-crésol, un groupe α-naphtol et un groupe β-naphtol,
et lorsque R2 est H, R1 ne peut pas être un groupe phényle ou naphtyle, et n vaut de 1 à 40 ; et
(B) un solvant,
dans lequel la viscosité inhérente du polyester aromatique contenant du phosphore de formule (I) n'est pas inférieure à 0,02 dl/g et n'est pas supérieure à 0,25 dl/g,
dans lequel
- la viscosité inhérente des polymères est déterminée à l'aide d'un viscosimètre Cannon-Fenske, en utilisant des solutions de polymères dans du N,N-diméthylformamide (DMF) à 25 °C, à une concentration de 20 g/dL et
- le poids moléculaire moyen en poids est mesuré par GPC.

2. La composition selon la revendication 1, dans laquelle le solvant (B) est un solvant utilisé dans la préparation de stratifiés revêtus de cuivre.

3. La composition de la revendication 1 dans laquelle R1 est 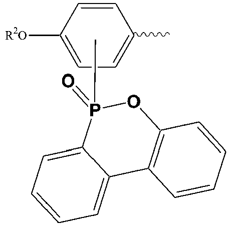 et où X est un groupe hydrocarboné aromatique bivalent de 6 à 12 atomes de carbone qui est éventuellement substitué par un groupe alkyle ou alcoxy de 6 atomes de carbone au maximum.

4. La composition selon la revendication 1, dans laquelle R1 est un groupe alkyle de 1 à 4 atomes de carbone et où X est un groupe hydrocarboné aromatique bivalent de 6 à 12 atomes de carbone qui est éventuellement substitué par un groupe alkyle ou alcoxy de 6 atomes de carbone au maximum.

5. La composition selon la revendication 1, dans laquelle R1 est 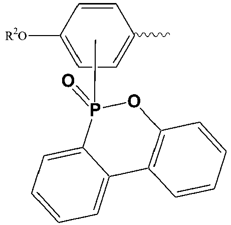 et où X est un groupe alkylène bivalent linéaire ou ramifié de 1 à 8 atomes de carbone, ou un groupe alcénylène bivalent linéaire ou ramifié de 2 à 8 atomes de carbone.

6. Composition selon la revendication 1, dans laquelle R1 est H ou un groupe alkyle de 1 à 4 atomes de carbone et où X est un groupe alkylène bivalent linéaire ou ramifié de 1 à 8 atomes de carbone, ou un groupe alcénylène bivalent linéaire ou ramifié de 2 à 8 atomes de carbone.

7. Composition selon la revendication 1, dans laquelle X est un groupe hydrocarboné aromatique bivalent de 6 à 12 atomes de carbone qui est éventuellement substitué par un groupe alkyle ou alcoxy de jusqu'à 6 atomes de carbone.

8. Composition selon la revendication 1, dans laquelle X est un groupe alkylène divalent linéaire ou ramifié de 1 à 8 atomes de carbone, ou un groupe alcénylène divalent linéaire ou ramifié de 2 à 8 atomes de carbone.

9. La composition selon la revendication 1, dans laquelle n est compris entre 1 et 40.

10. La composition selon la revendication 1, dans laquelle n est compris entre 2 et 40.

11. La composition selon la revendication 1, dans laquelle n est compris entre 2 et 20.

12. La composition selon la revendication 1, dans laquelle n est compris entre 3 et 20.

13. La composition selon la revendication 1, dans laquelle le solvant (B) est choisi dans le groupe constitué par la méthyléthylcétone, l'acétone, le 1-méthoxy-2-propanol, le tétrahydrofurane, le méthylcellosolve, le toluène, le xylène, le propylène glycol méthyl éther et son acétate, et leurs combinaisons.
